# FASCICULE DE BREVET EUROPEEN

(11) **EP 2 568 482 B1**
(45) Date de publication et mention de la délivrance du brevet: **21.01.2015**
(21) Numéro de dépôt: 12183233.1
(22) Date de dépôt: 05.09.2012
(51) Int. Cl.: H01F 7/20, H01F 5/00, G01R 33/04

(54) **Générateur d'un champ magnétique homogène**
Erzeuger eines homogenes Magnetfelds
Homogeneous magnetic field generator

(30) Priorité: 07.09.2011 FR 1157949
(43) Date de publication de la demande: 13.03.2013
(73) Titulaire: Commissariat à l'Énergie Atomique et aux Énergies Alternatives, 75015 Paris (FR)
(72) Inventeur: Klein, Philippe, 38830 SAINT PIERRE D'ALLEVARD (FR); Jeandey, Christian, 38120 SAINT EGREVE (FR)
(74) Mandataire: Colombo, Michel

(56) Documents cités:
- EP-A1- 1 481 637
- EP-A1- 1 873 543
- EP-A1- 2 259 081
- DE-A1- 10 148 288
- JP-A- S6 263 409
- JP-A- 2002 232 182
- JP-A- 2005 294 537
- M. E. PITTMAN ET AL: "Three and Four Coil Systems for Homogeneous Magnetic Fields", IEEE TRANSACTIONS ON AEROSPACE, vol. 2, no. 1, 1 janvier 1964 (1964-01-01) , pages 36-45, XP055060272, ISSN: 0536-1516, DOI: 10.1109/TA.1964.4319555
- JOSEPH L. KIRSCHVINK: "Uniform Magnetic Fields and Double-Wrapped Coil Systems: Improved Techniques for the Design of Bioelectromagnetic Experiments", BIOELECTROMAGNETICS, vol. 13, 1 janvier 1992 (1992-01-01), pages 401-411, XP055026345,
- MERRITT R ET AL: "Uniform magnetic field produced by three, four, and five square coils", REVIEW OF SCIENTIFIC INSTRUMENTS, AIP, MELVILLE, NY, US, vol. 54, no. 7, 1 juillet 1983 (1983-07-01), pages 879-882, XP002171520, ISSN: 0034-6748, DOI: 10.1063/1.1137480

## Description

L'invention concerne un générateur d'un champ magnétique homogène dans une sphère centrée sur un point central ainsi qu'un capteur de champ magnétique incorporant ce générateur.

Des générateurs connus comportent :
- au moins une première, une deuxième et une troisième bobines enroulées autour, respectivement, d'un premier, d'un deuxième et d'un troisième axes d'enroulement, les premier, deuxième et troisième axes d'enroulement étant orthogonaux entre eux et sécants en un point commun correspondant au point central,
- la ou les bobines enroulées autour d'un même axe d'enroulement étant agencées le long de cet axe d'enroulement de manière à ce qu'un plateau d'intensité du champ magnétique généré par cette ou ces bobines se produise au niveau du point central lorsque cette ou ces bobines sont traversées par un même courant.

Lorsque le plateau d'intensité des champs magnétiques générés selon chacun des trois axes orthogonaux se produit au niveau du point central, on dit que le champ magnétique est homogène. Plus précisément, un champ magnétique homogène est un champ dont au moins la dérivée première est nulle au niveau du point central. Lorsque seule la dérivée première est nulle, on dit qu'il s'agit d'un champ homogène d'ordre deux car la première dérivée non nulle dans la décomposition en série de Taylor du champ magnétique au niveau du point central est celui correspondant à la dérivée seconde.

Par la suite on dit qu'un champ magnétique est homogène d'ordre N, lorsque la première dérivée non nulle dans la décomposition en série de Taylor du champ magnétique au niveau du point central est celui correspondant à la dérivée N-ième.

On désigne également par « générateur d'ordre N », un générateur d'un champ magnétique homogène d'ordre N.

Lorsque le générateur génère un champ magnétique homogène dans trois directions orthogonales au niveau du même point central, le champ magnétique est homogène à l'intérieur d'une sphère centrée sur ce point central.

Actuellement ces générateurs sont complexes à fabriquer car ils sont réalisés en bobinant des fils dans des rainures réalisées sur une sphère en matériaux électriquement isolants.

Un générateur de l'état de la technique est également connu de :
- DE10148288A1,
- JP2005294537A,
- JP2002232182A,
- EP2259081A1,
- EP1873543A1,
- EP1481637A1,
- M. E. PITTMAN ET AL : « Three and Four Coil Systems for Homogeneous Magnetic Fields », IEEE Transaction on aerospace, vol. 2, no. 1, 1 janvier 1964 (1964-01-01), pages 36-45, ISSN : 0536-1516, DOI : 10.1109/TA.1964.4319555,
- Joseph L. KIRSCHVINK : « Uniform Magnetic Fields and Double-Wrapped Coil Systems : Improved Techniques for the Designe of Bioelectromagnetic Experiments », BIOELECTROMAGNETICES, vol. 13, 1 janvier 1992 (1992-01-01), pages 401-411,
- MERRITS R ET AL : « Uniform magnetic field produced by three, four, and five square coils », Review of scientific instruments, AIP, Melville, NY, US, vol. 54, no. 7, 1 juillet 1983 (1983-07-01), pages 879-88, ISSN : 0034-6748, DOI : 10.1063/1.1137480,
- J P S62 63409 A, et
- DE1 01 48 288.

Un générateur selon le préambule de la revendication 1 est connu de JP2005294537.

Cet état de la technique décrit des agencements de bobines plus simples à réaliser mais dont le champ magnétique n'est pas aussi homogène que celui généré par les générateurs plus complexes. De plus, leur encombrement est généralement assez important.

L'invention vise à remédier à cet inconvénient en proposant un générateur d'un champ magnétique plus homogène tout en préservant un encombrement aussi réduit que possible. Elle a donc pour objet un générateur conforme à la revendication 1.

Le générateur ci-dessus permet d'obtenir un champ magnétique homogène d'ordre huit alors que les générateurs décrit dans l'état de l'art précédemment introduit permettent au mieux de générer un champ magnétique homogène d'ordre quatre. De plus, du fait que la circonférence des bobines s'inscrit à proximité d'une sphère centrée sur le point central, le générateur reste très compact et de faible encombrement.

Les modes de réalisation de ce générateur peuvent comporter une ou plusieurs des caractéristiques des revendications dépendantes.

Ces modes de réalisation du générateur présentent en outre les avantages suivants :
- grâce aux encoches et épaulements, chaque circuit imprimé permet, en plus de remplir la fonction de support des pistes électriques, de positionner précisément les circuits imprimés les uns par rapport aux autres, ce qui simplifie l'assemblage et la fabrication du générateur de champ homogène ;
- raccorder en série les différentes bobines enroulées autour d'un même axe d'enroulement permet de simplifier la réalisation et l'utilisation de ce générateur ;
- réaliser des encoches dans les circuits imprimés de la deuxième bobine et des épaulements dans la carte du circuit imprimé de la première bobine permet de verrouiller simplement le circuit imprimé de la première bobine en position assemblée sans qu'il soit nécessaire pour cela d'utiliser d'autres moyens de fixation ;
- réaliser des encoches dans la carte du circuit imprimé de la troisième bobine et des épaulements correspondants dans la carte du circuit imprimé de la deuxième bobine permet de verrouiller simplement les circuits imprimés de la deuxième bobine en position assemblée sans qu'il soit nécessaire pour cela d'utiliser d'autres moyens de fixation.

L'invention a également pour objet un capteur d'un champ magnétique conforme à la revendication 8.

Un tel capteur présente une précision très nettement supérieure au capteur de champ magnétique utilisant des bobines de compensation enroulées autour de noyaux magnétiques respectifs pour travailler en champ nul à l'intérieur de ces noyaux magnétiques.

Les modes de réalisation de ce capteur peuvent comporter la caractéristique de la revendication 9.

Les modes de réalisation de ce capteur présentent en outre l'avantage suivant :
- réaliser les bobines du transducteur dans le même circuit imprimé que celui utilisé pour réaliser les bobines du générateur permet de limiter le nombre de circuits imprimés utilisés et simplifie donc la fabrication du capteur.

L'invention sera mieux comprise à la lecture de la description qui va suivre, donnée uniquement à titre d'exemple non limitatif et faite en se référant aux dessins sur lesquels :
- la figure 1 est une illustration schématique d'un capteur de champ magnétique ;
- la figure 2 est une illustration schématique et en perspective d'un premier mode de réalisation, non conforme à l'invention, d'un générateur de champ magnétique homogène utilisable dans le capteur de la figure 1 et permettant d'illustrer simplement l'assemblage d'un tel générateur;
- les figures 3 à 5 représentent chacune un circuit imprimé respectif utilisé pour réaliser le générateur de la figure 2 ;
- les figures 6 et 7 sont des illustrations schématiques d'étapes d'assemblage du générateur de la figure 2 ;
- la figure 8 est une illustration schématique du positionnement des bobines les unes par rapport aux autres dans le générateur de la figure 2 ;
- la figure 9 est un graphe représentant l'évolution du champ magnétique en fonction de la distance qui le sépare d'un point central O ;
- la figure 10 est une illustration schématique et en perspective d'un second mode de réalisation, conforme à l'invention, d'un générateur utilisable dans le capteur de la figure 1 ;
- les figures 11 à 13 sont des illustrations schématiques de circuits imprimés du générateur de la figure 10 ;
- la figure 14 est une illustration schématique du positionnement des bobines du générateur de la figure 10 ;
- la figure 15 est une illustration en perspective d'un troisième mode de réalisation, non conforme à l'invention, d'un générateur susceptible d'être utilisé dans le capteur de la figure 1 ;
- les figures 16 à 18 sont des illustrations schématiques de circuits imprimés utilisés pour réaliser le générateur de la figure 15 ;
- les figures 19 à 21 sont des illustrations schématiques de circuits imprimés utilisés pour réaliser un quatrième mode de réalisation, non conforme à l'invention, d'un générateur susceptible d'être utilisé dans le capteur de la figure 1.

Dans ces figures, les mêmes références sont utilisées pour désigner les mêmes éléments.

Dans la suite de cette description, les caractéristiques et fonctions bien connues de l'homme du métier ne sont pas décrites en détail.

Dans cette description, on désigne par « circuit imprimé », également plus connu sous l'acronyme PCB (Printed Circuit Board), un support permettant de relier électriquement un ensemble de composants électriques. Un tel circuit imprimé se présente généralement sous la forme d'une carte ou plaque stratifiée. Ce circuit imprimé peut être monocouche ou multicouche. Un circuit imprimé monocouche ne comporte qu'une seule couche de métallisation dans laquelle sont imprimées des pistes conductrices qui raccordent électriquement les différents composants électriques entre eux. Un circuit imprimé multicouche comporte, au contraire, plusieurs couches de métallisation c'est-à-dire au moins deux couches et, de préférence, plus de quatre ou six couches.

Une couche de métallisation est l'une des couches de la carte stratifiée formant le circuit imprimé dans laquelle sont réalisées une ou plusieurs pistes conductrices qui raccordent électriquement les différents composants électriques entre eux. Cette couche est plane et s'étend parallèlement au plan de la carte stratifiée. Généralement, la couche de métallisation est obtenue en déposant une couche uniforme d'un matériau conducteur, typiquement un métal tel que du cuivre, puis en gravant cette couche uniforme pour ne laisser subsister que les pistes conductrices.

Les différentes couches de métallisation du circuit imprimé sont espacées mécaniquement les unes des autres par des couches isolantes en matériau électriquement isolant. Ce matériau isolant présente une rigidité diélectrique élevée c'est-à-dire typiquement supérieure à 3 MV/m et, de préférence, supérieure à 10 MV/m. Par exemple, le matériau électriquement isolant est réalisé à partir de résine époxyde et/ou de fibre de verre. La couche isolante se présente généralement sous la forme d'une carte rigide réalisée dans un matériau qui ne devient pas visqueux lors de son assemblage avec d'autres couches. Par exemple, elle est réalisée à partir d'une résine thermodurcissable qui a déjà subi un thermodurcissement irréversible.

Les différentes couches du circuit imprimé multicouche sont assemblées les unes aux autres, sans aucun degré de liberté, à l'aide de couches adhésives appelées « pré-imprégné » et plus connues sous le terme anglais de « prepreg ».

Les pistes conductrices des différentes couches de métallisation peuvent être électriquement raccordées par l'intermédiaire de plots conducteurs traversant les couches isolantes. Les plots conducteurs sont plus connus sous le terme de « vias ». Les vias s'étendent généralement perpendiculaires au plan des couches. Il existe différentes façons de fabriquer ces vias. L'une des plus communes consiste à réaliser un trou dans la ou les couches isolantes à traverser puis à recouvrir d'un métal la paroi intérieure de ces trous. On parle alors de trous métallisés.

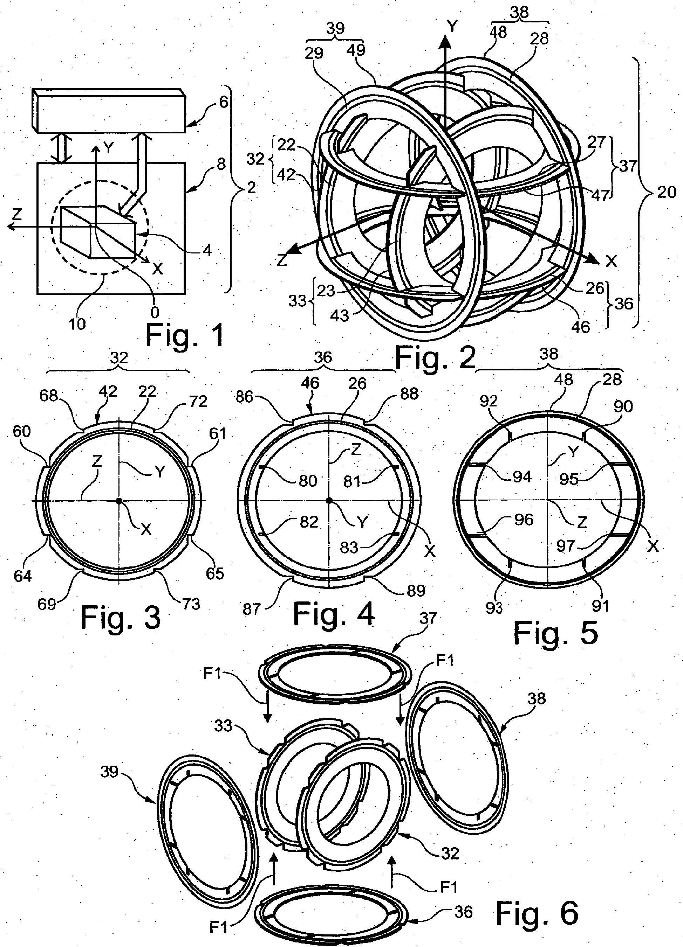

La figure 1 représente un capteur triaxial 2 d'un champ magnétique. Plus précisément, ce capteur 2 mesure l'intensité du champ magnétique le long de trois axes X, Y et Z orthogonaux entre eux et sécants entre eux en un point central O. Le capteur 2 mesure la projection orthogonale du champ magnétique sur chacun des axes X, Y et Z.

Ici, le capteur 2 est un capteur à vanne de flux plus connu sous le terme anglais de « Fluxgate ». Il comporte :
- un transducteur triaxial 4 capable de convertir le champ magnétique en tensions, et
- une unité 6 de traitement des tensions générées par le transducteur 4.

Le transducteur 4 comporte typiquement :
- au moins trois barreaux magnétiques saturables s'étendant, respectivement, le long des axes X, Y et Z,
- des bobines d'excitation enroulées autour de chacun de ces barreaux pour les saturer périodiquement,
- des bobines de mesure pour mesurer le champ magnétique dans chacun de ces barreaux.

Certains barreaux peuvent être raccordés magnétiquement les uns aux autres pour former un anneau magnétique. Par exemple, le transducteur 4 est identique au transducteur décrit dans la demande de brevet français déposée le 7 septembre 2011 par le Commissariat à l'énergie atomique et aux énergies alternatives et ayant pour titre « Circuit imprimé » (numéro de dépôt : FR 1157933) en référence à la figure 1 sauf que la bobine de compensation est omise.

L'unité 6 de traitement commande l'alimentation des bobines d'excitation et traite les mesures des bobines de mesure pour en déduire l'intensité du champ magnétique le long des axes X, Y et Z.

Le capteur 2 comporte également un générateur pilotable 8 de champ magnétique homogène. Ce générateur 8 génère un champ magnétique homogène à l'intérieur d'une sphère 10 d'homogénéité. La sphère 10 est la sphère centrée sur le point O et à l'intérieur de laquelle le champ magnétique est homogène dans la direction voulue et dont les trois composantes sont réglables dans les trois axes X,Y et Z.

Le transducteur 4 et notamment ses différents barreaux magnétiques sont placés à l'intérieur de cette sphère 10.

Ici, le générateur 8 est réalisé à l'aide de bobines de compensation enroulées, respectivement, autour des trois axes X, Y et Z. Des modes de réalisation de ce générateur 8 sont décrits plus en détail en référence aux figures suivantes.

L'unité 6 de traitement est également apte à commander le générateur 8 en fonction du champ magnétique mesuré selon les axes X, Y et Z pour générer à l'aide du générateur 8 un champ magnétique de compensation qui annule le champ magnétique mesuré. Ainsi, grâce au champ magnétique de compensation, le champ magnétique à l'intérieur des barreaux magnétiques du transducteur 4 est sensiblement nul. En d'autres termes, le générateur 8 remplace les bobines de compensation décrites dans la demande de brevet déposée sous le numéro FR1157933. Dans ces conditions, la mesure de l'intensité du champ magnétique selon les axes X, Y et Z est obtenue à partir de l'intensité du courant qui circule dans les bobines de compensation du générateur 8.

La figure 2 représente un générateur 20 du quatrième ordre, non conforme à l'invention, utilisable en tant que générateur 8. Ce générateur 20 est utilisé ici pour décrire sur un exemple simple une technique avantageuse de fabrication d'un tel générateur. Cette même technique est utilisée pour fabriquer les autres générateurs décrits en référence aux figures suivantes. Sur la figure 2, ce générateur 20 est représenté en position assemblée.

Le générateur 20 comprend :
- une paire de bobines 22, 23 enroulées autour de l'axe X,
- une paire de bobines 26, 27 enroulées autour de l'axe Y, et
- une paire de bobines 28, 29 enroulées autour de l'axe Z.

Chaque bobine comporte au moins une spire et de préférence plusieurs spires.

Ici, chaque paire de bobines forme une paire de bobines dite d'Helmholtz de manière à générer un champ magnétique homogène d'ordre quatre entre ces deux bobines dans leur axe d'enroulement.

Par exemple, la circonférence des spires des bobines forme un cercle centré sur leur axe d'enroulement. De plus, les deux bobines d'une même paire comportent le même nombre de spires.

La bobine 22 est le symétrique de la bobine 23 par rapport au plan YZ, c'est-à-dire par rapport au plan contenant les axes Y et Z. De façon similaire, les bobines 26 et 28 sont les symétriques, respectivement, des bobines 27 et 29 par rapport, respectivement, aux plans XZ et XY.

Pour former les bobines 22, 23 et 26 à 29, le générateur comprend six circuits imprimés, respectivement, 32, 33 et 36 à 39. Chaque circuit imprimé 32, 33 et 36 à 39 comprend une carte annulaire, respectivement, 42, 43 et 46 à 49 formant un support rigide pour des pistes électriques. Par rigide, on désigne par exemple une carte dont le module de Young à 25 °C est supérieur à 2 GPa et, de préférence, supérieur à 4 ou 10 ou 50 GPa.

Le circuit imprimé peut être un circuit imprimé monocouche ou multicouche.

Des pistes électriques circulaires sont réalisées dans des couches de métallisation de chacun des circuits imprimés pour former les spires, respectivement, des bobines 22, 23 et 26 à 29. Par exemple, ces pistes sont gravées dans les couches de métallisation des différentes cartes des différents circuits imprimés.

Les figures 3 à 5 représentent plus en détail, respectivement, les circuits imprimés 32, 36 et 38. Les circuits imprimés 33, 37 et 39 se déduisent, respectivement, des circuits imprimés 32, 36 et 38 par symétrie.

Dans ces figures, la projection orthogonale des axes X, Y et Z sur le plan du circuit imprimé porte les mêmes références numériques. L'axe perpendiculaire au plan du circuit imprimé est représenté par un point noir au centre de ce circuit imprimé.

La périphérie intérieure de la carte 42 est un cercle centré sur l'axe X. Sa périphérie extérieure est également un cercle centré sur l'axe X mais dans lequel des épaulements ont été découpés. Ici, la carte 42 comporte :
- deux épaulements 60, 61 destinés à venir en butée contre la carte 47 dans la position assemblée,
- deux épaulements 64, 65 destinés à venir en butée contre la carte 46 dans la position assemblée,
- deux épaulements 68, 69 destinés à venir en butée contre la carte 49 dans la position assemblée, et
- deux épaulements 72, 73 destinés à venir en butée contre la carte 48 dans la position assemblée.

Les épaulements 60, 64, 68 et 69 sont les symétriques, respectivement, des épaulements 61, 65, 72 et 73 par rapport au plan YX. Les épaulements 60, 61, 68 et 72 sont également les symétriques, respectivement, des épaulements 64, 65, 69 et 73 par rapport au plan ZX.

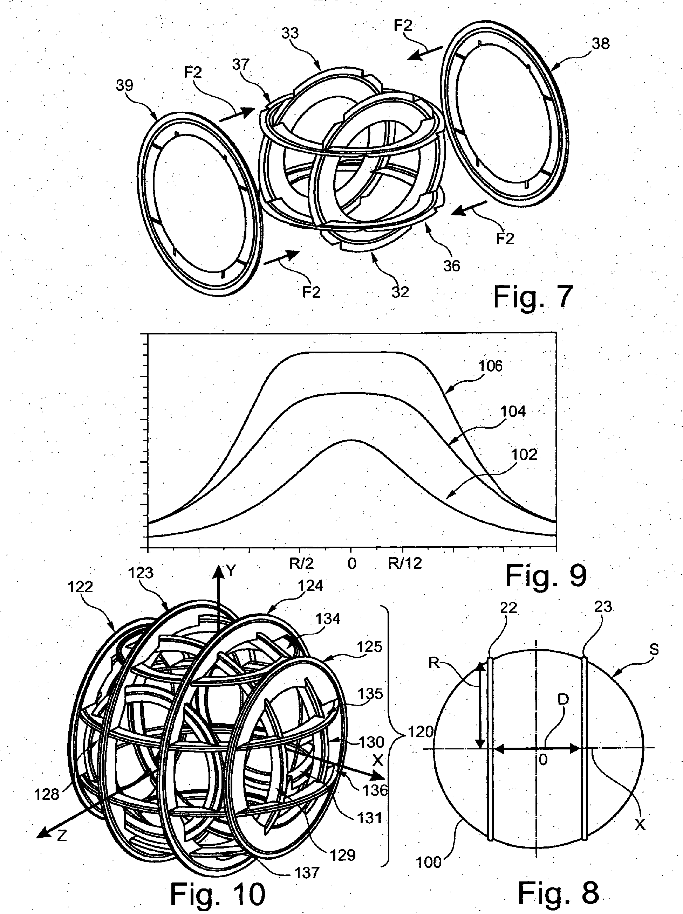

L'espacement entre les épaulements 60 et 64 et les épaulements 61 et 65 est choisi pour positionner les bobines 26 et 27 à une distance l'une de l'autre permettant d'obtenir un champ magnétique homogène le long de l'axe Y. Cette distance est décrite plus en détail en référence aux figures 8 et 9.

De même, l'espacement entre les épaulements 68, 72 et les épaulements 69, 73 est choisi pour positionner les bobines 28, 29 à une distance l'une de l'autre permettant d'obtenir un champ magnétique homogène le long de l'axe Z.

Les épaulements permettent aussi de positionner précisément et simplement à angle droit les différentes bobines du générateur 20.

La figure 4 représente le circuit imprimé 36. La périphérie intérieure de ce circuit imprimé est circulaire et centrée sur l'axe Y. Des encoches 80 à 83 sont découpées dans cette périphérie circulaire intérieure. Les encoches 80 et 82 sont les symétriques des encoches 81 et 83 par rapport au plan YZ. Les encoches 80 et 81 sont les symétriques des encoches 82 et 83 par rapport au plan XY. Les encoches 80, 81 et 82, 83 reçoivent en coulissant, lors de l'assemblage du générateur 20, respectivement, les cartes 42 et 43. Pour cela, la largeur de chaque encoche dans la direction parallèle à l'axe X est comprise entre e et 2e et, de préférence, comprise e + 5 µm et e + 300 µm, où e est l'épaisseur des cartes utilisées pour réaliser le générateur 20. De préférence, chaque encoche est plus profonde que large.

Ici, chaque encoche immobilise en translation dans la direction X la carte reçue 42 ou 43 dans cette encoche.

La périphérie extérieure circulaire du circuit 36 est centrée sur l'axe Y. Des épaulements 86 à 89 sont découpés dans cette périphérie extérieure pour positionner les circuits imprimés 48 et 49. Plus précisément, les épaulements 86, 87 viennent en butée contre la carte 49 en position assemblée. Les épaulements 88 et 89 viennent quant à eux en butée contre la carte 48 en position assemblée.

Les épaulements 86 et 87 sont les symétries des épaulements 88 et 89 par rapport au plan YZ. Les épaulements 86 et 88 sont les symétries des épaulements 87 et 89 par rapport au plan XY.

L'espacement entre les épaulements 86, 88 et les épaulements 87, 89 est choisi pour positionner les bobines 28, 29 à une distance l'une de l'autre qui permet de générer un champ magnétique homogène le long de l'axe Z.

La figure 5 représente le circuit imprimé 38. Sa périphérie intérieure circulaire est centrée sur l'axe Z. Des encoches 90 à 97 sont découpées dans cette périphérie intérieure. Ces encoches remplissent une fonction similaire et sont réalisées de façon similaire à ce qui a été décrit précédemment pour les encoches du circuit imprimé 36. Ici, les encoches 92, 93, 94 et 96 sont les symétriques, respectivement, des encoches 90, 91, 95 et 97 par rapport au plan YZ. Les encoches 90, 92, 94 et 95 sont les symétriques, respectivement, des encoches 91, 93, 96 et 97 par rapport au plan XZ.

Les encoches 90, 91 et les encoches 92, 93 reçoivent en coulissant, lors de l'assemblage, respectivement les cartes 42 et 43.

Les encoches 94, 95 et les encoches 96, 97 reçoivent en coulissant, lors de l'assemblage, respectivement, les cartes 47 et 46.

Les encoches 90 à 97 permettent de verrouiller en translation le long des axes X et Y les circuits imprimés 32, 33 et 36, 37.

La figure 6 représente la première étape d'assemblage du générateur 20. Plus précisément, la figure 6 représente la position désassemblée du générateur 20. Pour commencer l'assemblage, les circuits imprimés 32 et 33 sont assemblés avec les circuits imprimés 36 et 37 par translation le long des flèches F1. Pour cela, les circuits imprimés 32 et 33 sont insérés à l'intérieur, respectivement des paires d'encoches 80, 81 et 82, 83 des circuits imprimés 36 et 37. Lors de cette opération, les circuits imprimés 36 et 37 viennent en butée contre les épaulements correspondants réalisés dans les circuits 32 et 33.

La figure 7 représente l'étape suivante d'assemblage lors de laquelle les circuits imprimés 38 et 39 sont assemblés sur les circuits imprimés précédents. Pour cela, les circuits 38 et 39 sont déplacés en translation selon la direction des flèches F2. On obtient alors après cette translation le générateur 20 en position assemblée. Dans cette position, les circuits 38 et 39 verrouillent en position les circuits 32, 33, 36 et 37. Des points de colle sont utilisés pour fixer, sans aucun degré de liberté, les circuits imprimés 38 et 39 aux autres circuits imprimés. Ces points de colle permettent donc de verrouiller en position assemblée le générateur 20.

La figure 8 représente l'écartement entre les bobines 22 et 23. L'écartement entre les autres paires de bobines est choisi de façon identique. Ici, la distance D selon l'axe X qui sépare les bobines 22 et 23 est égale au rayon R de ces bobines. Dans ces conditions, le champ magnétique généré par les bobines 22 et 23 est homogène d'ordre quatre à l'intérieur de la sphère 10. Cette configuration est également connue sous le nom de bobines d'Helmholtz.

Ici, l'écartement des deux bobines enroulées sur le même axe est fixé par l'écartement entre les épaulements sur lequel les circuits imprimés reposent. L'écartement des épaulements est donc choisi pour que chaque paire de bobines forme des bobines d'Helmholtz.

Les circonférences des bobines 22 et 23 sont inscrites dans une sphère S centrée sur le point O. Dans cette configuration, l'encombrement du générateur 20 est minimisé.

La figure 9 représente l'évolution de l'intensité du champ magnétique le long de l'axe X en fonction de la distance au centre dans différents cas où un champ magnétique homogène est généré au niveau du point central O.

La courbe 102 représente le cas d'une seule bobine circulaire contenue dans le plan YZ. Les courbes 104 et 106 représentent le cas, respectivement, de deux bobines et de quatre bobines. Comme illustré, en utilisant un plus grand nombre de bobines, il est possible de générer un champ magnétique plus homogène. Par exemple, ici, une seule bobine centrée sur le point O permet uniquement de générer un champ magnétique homogène d'ordre deux. Par contre, deux bobines permettent de générer un champ magnétique homogène d'ordre quatre. Enfin, quatre bobines permettent de générer un champ magnétique homogène d'ordre huit.

La figure 10 représente un générateur 120 d'ordre huit, conforme à l'invention, en position assemblée. Ce générateur 120 est susceptible d'être utilisé en tant que générateur 8 dans le capteur 2. Il est réalisé selon le même principe que le générateur 20 mais comporte des bobines supplémentaires pour générer un champ magnétique homogène d'ordre huit.

A cet effet, le générateur 120 comporte :
- quatre circuits imprimés annulaires 122 à 125 centrés sur l'axe X, disposés de façon symétrique par rapport au plan YZ,
- quatre circuits imprimés annulaires 128 à 131 centrés sur l'axe Z, disposés de façon symétrique par rapport au plan XY, et
- quatre circuits imprimés annulaires 134 à 137 centrés sur l'axe Y, disposés de façon symétrique par rapport au plan XZ.

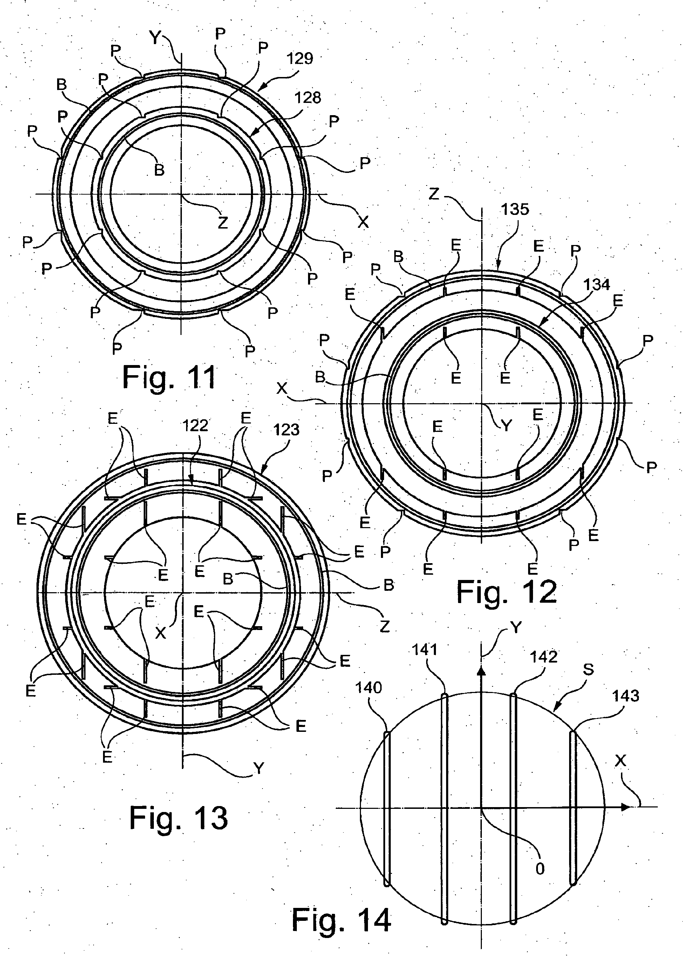

Les figures 11 à 13 représentent plus en détail les circuits imprimés 122, 123, 128, 129, 134 et 135. Les autres circuits imprimés du générateur 120 se déduisent de ces circuits imprimés par symétrie par rapport aux plans XY, XZ ou YZ.

Comme pour le générateur 20, chaque circuit imprimé comprend une carte rigide dans laquelle sont réalisées des pistes électriques formant les spires des bobines et dans laquelle sont découpés des encoches et/ou des épaulements pour positionner ces circuits imprimés les uns par rapport aux autres. Sur les figures 11 à 13 et suivantes, les bobines portent la référence B, les encoches portent la référence E et les épaulements portent la référence P.

Les encoches E et les épaulements P sont écartés les uns des autres de manière à positionner les bobines dans une position où le champ magnétique généré est homogène d'ordre huit.

La figure 14 représente la position, le long de l'axe X, des bobines circulaires 140 à 143 gravées dans les couches de métallisation des circuits imprimés122 à 125. La position C_{X} le long de l'axe X et le rayon R_{Y} de chaque bobine pour obtenir un champ magnétique homogène d'ordre huit sont déterminés par calcul à partir des équations de la magnétostatique. Le nombre de solutions étant infini dans cette configuration, la solution est sélectionnée pour vérifier en plus les deux contraintes supplémentaires suivantes :
1) la circonférence de chaque bobine doit être aussi proche que possible de la périphérie d'une sphère S de rayon choisi centrée sur le point O, et
2) pour un courant d'intensité unitaire circulant dans les bobines 141 et 142, l'intensité du courant permettant d'obtenir un champ magnétique homogène d'ordre huit circulant dans les bobines d'extrémité 140 et 143 doit être une fraction rationnelle du courant unitaire.

La condition 1) permet d'accroître la compacité du générateur 120. La contrainte 2) permet d'avoir un nombre entier de spires dans chaque bobine 140 à 143. Pour une sphère de rayon unitaire, la position C_{X} et le rayon C_{Y} de chaque bobine 140 à 143 sont donnés dans le tableau suivant.

| Référence numérique de la bobine | 140 | 141 | 142 | 143 |
|---|---|---|---|---|
| C_{X} | -0,764 | 0,287 | 0,287 | 0,764 |
| C_{Y} | 0,641 | 0,961 | 0,961 | 0,641 |

Avec ces valeurs, l'écart entre les diamètres des bobines et le diamètre du cercle correspondant à l'intersection entre le plan du circuit imprimé de la bobine et de la sphère S est inférieur à 2 % et, ici, inférieur ou égal à 0,5 %. L'écart est donné en prenant comme référence le diamètre de la sphère S.

L'intensité du courant dans les bobines 140 et 143 est réduite d'un tiers par rapport à l'intensité du courant circulant dans les bobines 141 et 142 pour obtenir un champ magnétique homogène d'ordre huit. Dès lors, pour réaliser cette configuration, les bobines 140 à 143 sont raccordées en série pour être traversées par le même courant de compensation. Le nombre de spires des bobines 141, 142 est alors choisi comme étant un multiple entier de trois. Dans ces conditions, le nombre de spires des bobines 140 et 143 est aussi un nombre entier. Il est déduit du nombre de spires des bobines 141, 142 en multipliant ce nombre par 2/3. Par exemple, les bobines 141 et 142 sont formées uniquement par trois spires et les bobines 140 et 143 sont formées uniquement de deux spires. Un tel choix facilite également la réalisation du générateur.

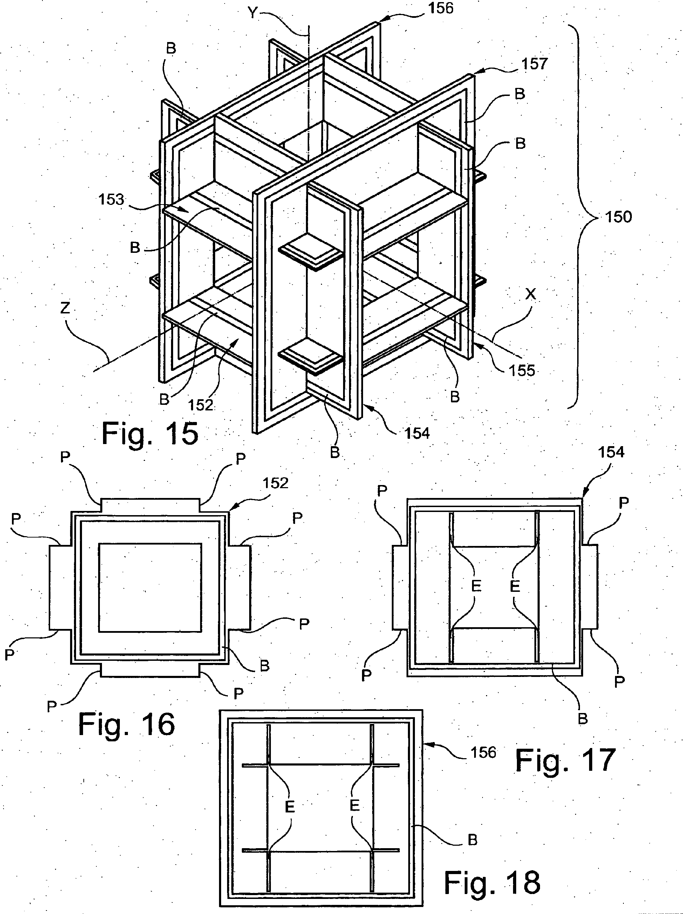

Les figures 15 à 18 représentent un générateur 150 d'ordre quatre, non conforme à l'invention, identique au générateur 20 mais réalisé en utilisant des bobines de section carrée. Ici, ce générateur 150 comporte six circuits imprimés 152 à 157 ayant un périmètre extérieur carré et un pourtour intérieur également carré. Comme dans les modes de réalisation précédents, le positionnement des circuits imprimés les uns par rapport aux autres est obtenu par coopération de forme entre des encoches E et des épaulement P découpés sur la périphérie des cartes de ces circuits imprimés.

Etant donné que les bobines sont carrées, l'écartement entre les différentes bobines pour obtenir un champ magnétique homogène d'ordre quatre n'est pas exactement le même que celui utilisé lorsque les bobines sont circulaires. Il a été calculé à partir des équations de la magnétostatique que l'écartement entre les bobines carrées peut être déduit de l'écartement D entre les bobines circulaires en multipliant ce dernier écartement par 1,089.

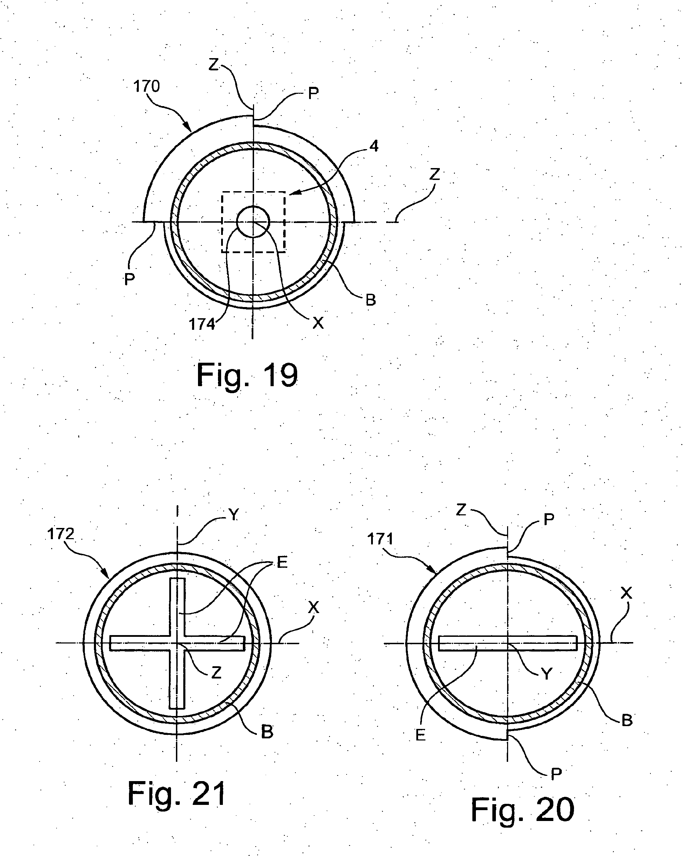

Les figures 19 à 21 représentent trois circuits imprimés 170 à 172 permettant de réaliser un générateur d'ordre deux, non conforme à l'invention. Dans ce cas, les trois bobines des trois circuits imprimés sont concentriques et admettent comme centre le même point central O. Chacune de ces bobines est placée dans un plan perpendiculaire aux plans des deux autres bobines. Dans ce mode de réalisation, les encoches E sont des rectangles découpés au centre des cartes des circuits imprimés 171 et 172 pour recevoir en coulissant la carte d'un autre circuit imprimé. Ainsi, en position assemblée, le circuit imprimé 170 est reçu à l'intérieur de l'encoche E du circuit 171 et l'assemblage des circuits 170 et 171 est reçu à l'intérieur des encoches E du circuit 172.

De plus, dans ce mode de réalisation, des spires 174 d'au moins une des bobines du transducteur 4 sont formées par des pistes conductrices réalisées dans des couches de métallisation du circuit imprimé 170 de manière à faciliter la fabrication du capteur.

De nombreux autres modes de réalisation sont possibles. Par exemple, les multiples spires d'une même bobine peuvent être réalisées dans une même couche de métallisation du circuit imprimé ou dans des couches respectives de métallisation empilées les unes au-dessus des autres. Dans ce cas, typiquement, les différentes spires sont reliées par des vias. Quel que soit l'ordre du générateur, il est possible d'utiliser des spires carrées au lieu des spires circulaires. D'autres formes de spires sont également possibles.

Le collage des circuits imprimés entre eux peut être réalisé par d'autres moyens que de la colle. Par exemple, un point de soudure peut être utilisé pour fixer les circuits imprimés entre eux. Ce point de soudure sera réalisé entre des plages réservées à cet usage.

Des générateurs d'ordre supérieur à huit sont également réalisés en ajoutant des bobines et donc des circuits imprimés.

On notera qu'un générateur d'ordre six, non conforme à l'invention, peut être réalisé en disposant trois bobines le long de chaque axe X, Y et Z. L'une des trois bobines est comprise dans un plan passant par le point O.

En variante, les circuits imprimés utilisés pour réaliser les bobines du générateur peuvent être positionnées les unes par rapport aux autres sans recours à des encoches ou des épaulements. Par exemple, les circuits imprimés sont placés en position l'un par rapport à l'autre manuellement ou à l'aide d'un robot puis fixés sans aucun degrés de liberté l'un à l'autre par un moyen de fixation tel que de la colle ou un point de soudure.

Dans une autre variante les spires des bobines ne sont pas réalisées par des pistes électriques d'un circuit imprimé. Par exemple, les spires des bobines sont obtenues en bobinant un fil dans des encoches circulaires réalisées sur la périphérie d'un globe en matériau non magnétique.

## Revendications

1. Générateur d'un champ magnétique homogène (120) dans une sphère centrée sur un point central, ce générateur comportant :
- des bobines (122-125, 128-131, 134-137, B) enroulées autour, respectivement, d'un premier, d'un deuxième et d'un troisième axes (X, Y, Z) d'enroulement, les premier, deuxième et troisième axes d'enroulement étant orthogonaux entre eux et sécants en un point commun correspondant au point central, les bobines enroulées autour d'un même axe d'enroulement étant agencées le long de cet axe d'enroulement de manière à ce qu'un plateau d'intensité du champ magnétique généré par ces bobines se produise au niveau du point central lorsque ces bobines sont traversées par un même courant,
- le générateur comportant au moins quatre de ces bobines enroulées autour de chacun des axes d'enroulement, les quatre bobines enroulées autour du même axe d'enroulement formant deux paires de bobines, chaque bobine d'une paire étant le symétrique de l'autre bobine de la paire par rapport à un plan de symétrie perpendiculaire à cet axe d'enroulement et passant par le point central, **caractérisé en ce que**, pour chaque axe d'enroulement, les quatre bobines (122-125, 128-131, 134-137, B) enroulée autour de cet axe sont espacées les unes des autres de manière à annuler au moins la dérivée première jusqu'à la dérivée septième du champ magnétique généré par ces bobines, parallèlement à l'axe d'enroulement, au niveau du point central lorsqu'elles sont alimentées par le même courant, et
- la circonférence de chaque bobine est un cercle, le diamètre de ce cercle étant égal, à plus ou moins 2% près, au diamètre d'un cercle défini par l'intersection d'une sphère centrée sur le point central et d'un plan, perpendiculaire à l'axe d'enroulement de cette bobine, passant par cette bobine, la sphère étant la même pour toutes les bobines enroulées autour du même axe d'enroulement.

2. Générateur selon la revendication 1, dans lequel les différentes bobines enroulées autour d'un même axe d'enroulement sont électriquement raccordées en série et positionnées le long de l'axe d'enroulement de manière à ce que chaque bobine comporte un nombre entier de spires.

3. Générateur selon l'une quelconque des revendications précédentes, dans lequel le générateur comporte, pour chaque bobine, un circuit imprimé (122-125, 128-131, 134-137) dans lequel sont réalisées des pistes électriques formant les spires de cette bobine, ce circuit imprimé comprenant une carte rigide formant un support pour ces pistes électriques.

4. Générateur selon la revendication 3, dans lequel au moins l'une de ces cartes comporte également au moins une encoche apte, par coopération de forme, avec un épaulement (P) d'une carte d'un des autres circuits imprimés à positionner cet autre circuit imprimé par rapport à cette carte dans une position où le plateau d'intensité du champ magnétique généré par les bobines se produit au niveau du point central lorsque ces bobines sont traversées par un même courant.

5. Générateur selon la revendications 4, dans lequel :
- la carte du circuit imprimé de chaque bobine enroulée autour du deuxième axe comporte au moins une encoche (E) apte à recevoir en coulissant la carte du circuit imprimé d'une bobine enroulée autour du premier axe, et
- la carte du circuit imprimé de chaque bobine enroulée autour du premier axe comporte au moins un épaulement (P) apte à venir en butée contre la carte du circuit imprimé d'une bobine enroulée autour du deuxième axe lorsque cette carte coulisse dans l'encoche de la carte du circuit imprimé de cette bobine enroulée autour du deuxième axe.

6. Générateur selon la revendication 5, dans lequel :
- la carte du circuit imprimé de chaque bobine enroulée autour du troisième axe comporte des encoches (E) aptes à recevoir en coulissant la carte du circuit imprimé d'une bobine enroulée autour du deuxième axe, et
- la carte du circuit imprimé de chaque bobine enroulée autour du deuxième axe comporte des épaulements (P) aptes à venir en butée contre la carte du circuit imprimé d'une bobine enroulée autour du troisième axe lorsque cette carte coulisse dans l'encoche de la carte du circuit imprimé de cette bobine enroulée autour du troisième axe.

7. Générateur selon l'une quelconque des revendications 4 à 6, dans lequel chaque encoche est délimitée par deux bords parallèles séparés l'un de l'autre par une distance d comprise entre e et 2e, où e est égal à l'épaisseur de la carte reçue en coulissant dans cette encoche.

8. Capteur d'un champ magnétique, ce capteur comportant :
- un générateur (8) pilotable de champ magnétique apte à générer un champ magnétique homogène dont un plateau d'intensité, dans trois directions orthogonales, se produit en un point central,
- un transducteur triaxial (4) apte à convertir l'intensité du champ magnétique dans lesdites trois directions orthogonales en des tensions respectives, ce transducteur étant placé au niveau du point central, et
- une unité (6) de commande apte à commander le générateur en fonction du champ magnétique mesuré par le transducteur pour annuler le champ magnétique mesuré au niveau du point central,
**caractérisé en ce que** le générateur (8) est conforme à l'une quelconque des revendications précédentes.

9. Capteur selon la revendication 8, dans lequel le transducteur triaxial (4) comporte au moins une bobine de mesure pour mesurer le champ magnétique le long d'au moins l'une desdites trois directions et le générateur (8) comporte un circuit imprimé dans lequel sont réalisées des pistes électriques formant des spires de cette bobine de mesure et d'autres pistes électriques formant des spires d'une des bobines (B) du générateur.

## Patentansprüche

1. Generator (120) für die Erzeugung eines homogenen Magnetfeldes in einer auf einen Mittelpunkt zentrierten Kugel, wobei dieser Generator Folgendes umfasst:
- Spulen (122-125, 128-131, 134-137, B), die um eine erste bzw. eine zweite bzw. eine dritte Wicklungsachse (X, Y, Z) gewickelt sind, wobei die erste, die zweite und die dritte Wicklungsachse zueinander senkrecht sind und sich in einem gemeinsamen Punkt, der dem Mittelpunkt entspricht, schneiden, wobei die um dieselbe Wicklungsachse gewickelten Spulen längs dieser Wicklungsachse in der Weise angeordnet sind, dass ein Intensitätsniveau des durch diese Spulen erzeugten Magnetfeldes auf Höhe des Mittelpunkts entsteht, wenn diese Spulen von einem Strom durchflossen werden,
- wobei der Generator wenigstens jeweils vier dieser Spulen, die um jede der Wicklungsachsen gewickelt sind, umfasst, wobei die vier um dieselbe Wicklungsachse gewickelten Spulen zwei Spulenpaare bilden, wobei jede Spule eines Paars in Bezug auf eine Symmetrieebene, die zu dieser Wicklungsachse senkrecht ist und durch den Mittelpunkt verläuft, zu der anderen Spule des Paars symmetrisch ist, **dadurch gekennzeichnet, dass** für jede Wicklungsachse die vier Spulen (122-125, 128-131, 134-137, B), die um diese Achse gewickelt sind, voneinander so beabstandet sind, dass wenigstens die ersten bis siebten Ableitungen des durch diese Spulen erzeugten Magnetfeldes parallel zu dieser Wicklungsachse auf Höhe des Mittelpunkts verschwinden, wenn sie vom selben Strom durchflossen werden, und
- der Umfang jeder Spule ein Kreis ist, der Durchmesser dieses Kreises gleich oder bis auf weniger 2 % gleich dem Durchmesser eines Kreises ist, der durch den Schnitt einer auf den Mittelpunkt zentrierten Kugel und einer Ebene senkrecht zu der Wicklungsachse dieser Spule, die durch diese Spule verläuft, definiert ist, wobei die Kugel für alle Spulen, die um dieselbe Wicklungsachse gewickelt sind, die gleiche ist.

2. Generator nach Anspruch 1, wobei die verschiedenen Spulen, die um dieselbe Wicklungsachse gewickelt sind, elektrisch in Reihe geschaltet sind und längs der Wicklungsachse positioniert sind, derart, dass jede Spule eine ganzzahlige Anzahl von Windungen besitzt.

3. Generator nach einem der vorhergehenden Ansprüche, wobei der Generator für jede Spule eine gedruckte Schaltung (122-125, 128-131, 134-137) umfasst, in der elektrische Bahnen verwirklicht sind, die die Windungen dieser Spule bilden, wobei diese gedruckte Schaltung eine starre Karte aufweist, die einen Träger für diese elektrischen Bahnen bildet.

4. Generator nach Anspruch 3, wobei wenigstens eine dieser Karten außerdem wenigstens eine Nut aufweist, die durch Formzusammenwirkung mit einer Schulter (P) einer Karte einer der anderen gedruckten Schaltungen diese andere gedruckte Schaltung in Bezug auf diese Karte in einer Position positionieren kann, in der das Intensitätsniveau des durch die Spulen erzeugten Magnetfeldes auf Höhe des Mittelpunkts entsteht, wenn diese Spulen vom selben Strom durchflossen werden.

5. Generator nach Anspruch 4, wobei:
- die Karte der gedruckten Schaltung jeder Spule, die um dieselbe Achse gewickelt ist, wenigstens eine Nut (E) aufweist, die die Karte der gedruckten Schaltung einer um die erste Achse gewickelten Spule gleitend aufnehmen kann, und
- die Karte der gedruckten Schaltung jeder Spule, die um die erste Achse gewickelt ist, wenigstens eine Schulter (P) aufweist, die an der Karte der gedruckten Schaltung einer Spule, die um die zweite Achse gewickelt ist, in Anschlag gelangen kann, wenn diese Karte in die Nut der Karte der gedruckten Schaltung dieser Spule, die um die zweite Achse gewickelt ist, gleitet.

6. Generator nach Anspruch 5, wobei:
- die Karte der gedruckten Schaltung jeder Spule, die um die dritte Achse gewickelt ist, Nuten (E) aufweist, die die Karte der gedruckten Schaltung einer Spule, die um die zweite Achse gewickelt ist, gleitend aufnehmen kann, und
- die Karte der gedruckten Schaltung jeder Spule, die um die zweite Achse gewickelt ist, Schultern (P) aufweist, die an der Karte der gedruckten Schaltung einer Spule, die um die dritte Achse gewickelt ist, in Anschlag gelangen kann, wenn diese Karte in die Nut der Karte der gedruckten Schaltung dieser Spule, die um die dritte Achse gewickelt ist, gleitet.

7. Generator nach einem der Ansprüche 4 bis 6, wobei jede Nut durch zwei parallele Ränder begrenzt ist, die voneinander durch einen Abstand d getrennt sind, der im Bereich von e bis 2e liegt, wobei e gleich der Dicke der Karte ist, die in dieser Nut gleitend aufgenommen wird.

8. Magnetfeldsensor, wobei dieser Sensor Folgendes umfasst:
- einen steuerbaren Magnetfeldgenerator (8), der ein homogenes Magnetfeld erzeugen kann, dessen Intensitätsniveau in drei zueinander senkrechten Richtungen an einem Mittelpunkt entsteht,
- einen dreiachsigen Wandler (4), der die Intensität des Magnetfeldes in den drei zueinander senkrechten Richtungen in jeweilige Spannungen umsetzen kann, wobei dieser Wandler auf Höhe des Mittelpunkts angeordnet ist, und
- eine Steuereinheit (6), die den Generator als Funktion des von dem Wandler gemessenen Magnetfeldes steuern kann, um das Magnetfeld, das auf Höhe des Mittelpunkts gemessen wird, zu null zu machen,
**dadurch gekennzeichnet, dass** der Generator (8) wie in einem der vorhergehenden Ansprüche definiert beschaffen ist.

9. Sensor nach Anspruch 8, wobei der dreiachsige Wandler (4) wenigstens eine Messspule umfasst, um das Magnetfeld längs wenigstens einer der drei zueinander senkrechten Richtungen zu messen, und der Generator (8) eine gedruckte Schaltung umfasst, in der elektrische Bahnen verwirklicht sind, die Windungen dieser Messspule bilden, und andere elektrische Bahnen verwirklicht sind, die Windungen einer der Spulen (B) des Generators bilden.

## Claims

1. Homogeneous magnetic field generator (120) in a sphere centred on a central point, this generator comprising:
- coils (122-125, 128-131, 134-137, B) wound around, respectively, a first, a second, and a third winding axes (X, Y, Z), the first, second and third winding axes being mutually orthogonal and secant at a common point corresponding to the central point, the coils wound around one and the same winding axis being arranged along this winding axis in such a way that a plateau of intensity of the magnetic field generated by these coils is produced at the central point when these coils are passed through by one and the same current,
- the generator comprising at least four of these coils wound around each of the winding axes, the four coils wound around the same winding axis forming two pairs of coils, each coil of a pair being symmetrical with the other coil of the pair relative to a plane of symmetry at right angles to this winding axis and passing through the central point, **characterized in that**, for each winding axis, the four coils (122-125, 128-131, 134-137, B) wound around this axis are spaced apart from one another in such way as to cancel at least the first derivative up to the seventh derivative of the magnetic field generated by these coils, parallel to the winding axis, at the central point when they are powered by the same current, and
- the circumference of each coil is a circle, the diameter of this circle being equal, to within plus or minus 2%, to the diameter of a circle defined by the intersection of a sphere centred on the central point and of a plane, at right angles to the winding axis of this coil, passing through this coil, the sphere being the same for all the coils wound around the same winding axis.

2. Generator according to Claim 1, in which the different coils wound around one and the same winding axis are electrically connected in series and positioned along the winding axis in such a way that each coil comprises an integer number of turns.

3. Generator according to any one of the preceding claims, in which the generator comprises, for each coil, a printed circuit (122-125, 128-131, 134-137) in which electrical tracks are produced forming the turns of this coil, this printed circuit comprising a rigid board forming a support for these electrical tracks.

4. Generator according to Claim 3, in which at least one of these boards also comprises at least one notch suitable, by cooperation of form, with a shoulder (P) of a board of one of the other printed circuits, for positioning this other printed circuit relative to this board in a position in which the plateau of intensity of the magnetic field generated by the coils is produced at the central point when these coils are passed through by one and the same current.

5. Generator according to Claim 4, in which:
- the board of the printed circuit of each coil wound around the second axis comprises at least one notch (E) suitable for slidingly receiving the board of the printed circuit of a coil wound around the first axis, and
- the board of the printed circuit of each coil wound around the first axis comprises at least one shoulder (P) suitable for abutting against the board of the printed circuit of a coil wound around the second axis when this board slides into the notch of the board of the printed circuit of this coil wound around the second axis.

6. Generator according to Claim 5, in which:
- the board of the printed circuit of each coil wound around the third axis comprises notches (E) suitable for slidingly receiving the board of the printed circuit of a coil wound around the second axis, and
- the board of the printed circuit of each coil wound around the second axis comprises shoulders (P) suitable for abutting against the board of the printed circuit of a coil wound around the third axis when this board slides into the notch of the board of the printed circuit of this coil wound around the third axis.

7. Generator according to any one of Claims 4 to 6, in which each notch is delimited by two parallel edges separated from one another by a distance d of between e and 2e, where e is equal to the thickness of the board slidingly received in this notch.

8. Sensor of a magnetic field, this sensor comprising:
- a controllable magnetic field generator (8) suitable for generating a homogeneous magnetic field of which a plateau of intensity, in three orthogonal directions, is produced at a central point,
- a triaxial transducer (4) suitable for converting the intensity of the magnetic field in said three orthogonal directions into respective voltages, this transducer being placed at the central point, and
- a control unit (6) suitable for controlling the generator as a function of the magnetic field measured by the transducer to cancel the magnetic field measured at the central point,
**characterized in that** the generator (8) conforms to any one of the preceding claims.

9. Sensor according to Claim 8, in which the tri-axial transducer (4) comprises at least one measurement coil for measuring the magnetic field along at least one of said three directions and the generator (8) comprises a printed circuit in which electrical tracks are produced forming turns of this measurement coil and other electrical tracks are produced forming turns of one of the coils (B) of the generator.
